Europäisches Patentamt

European Patent Office

Office européen des brevets

(11) Veröffentlichungsnummer: **0 439 652 A1**

# (12) EUROPÄISCHE PATENTANMELDUNG

(21) Anmeldenummer: 90101915.8

(22) Anmeldetag: 31.01.90

(51) Int. Cl.5: **H01L 23/495, H01L 23/66**

(43) Veröffentlichungstag der Anmeldung:
**07.08.91 Patentblatt 91/32**

(84) Benannte Vertragsstaaten:
**AT BE CH DE DK ES FR GB GR IT LI LU NL SE**

(71) Anmelder: **Siemens Aktiengesellschaft**
**Wittelsbacherplatz 2**
**W-8000 München 2(DE)**

(72) Erfinder: **Hargasser, Hans, Dipl.-Ing. (FH)**
**Salzmannstrasse 46**
**W-8000 München 83(DE)**

(54) **Hochfrequenz-SMD-Transistor mit zwei Emitteranschlüssen.**

(57) Ein Hochfrequenz-SMD-Transistor mit zwei Emitter-Anschlüssen, bei dem ein Halbleitertransistor-Chip (6) auf einem Leiterband (9) befestigt und mit elektrischen Anschlüssen (1 bis 4) auf dem Leiterband (9) kontaktiert ist, soll die kleinste, technisch mögliche Emitter-Induktivität aufweisen. Die beiden Emitter-Anschlüsse des Hochfrequenz-SMD-Transistors sind innerhalb des Leiterbands (9) einstückig ausgebildet. Zwischen dem Emitter des Halbleitertransistor-Chips (6) und des einstückig ausgebildeten beiden Emitter-Anschlüssen sind zwei elektrische Verbindungen (10, 11) vorhanden.

FIG 12

EP 0 439 652 A1

## HOCHFREQUENZ-SMD-TRANSISTOR MIT ZWEI EMITTERANSCHLÜSSEN

Die Erfindung betrifft einen Hochfrequenz-SMD-Transistor mit zwei Emitteranschlüssen nach dem Oberbegriff des Patentanspruchs 1 und ein Leiterband (Lead Frame) nach dem Oberbegriff des Patentanspruchs 5.

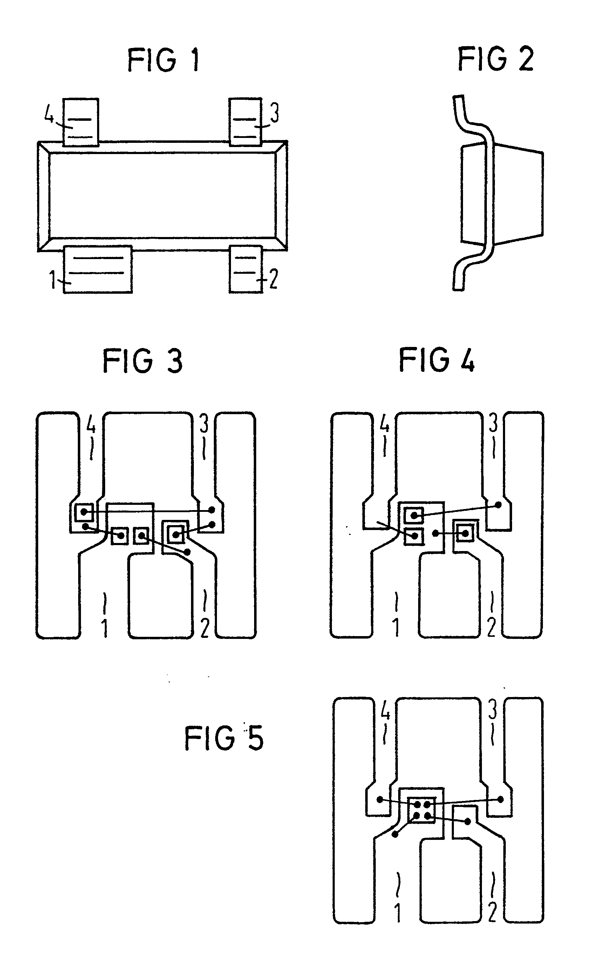

Insbesondere bezieht sich die Erfindung auf die SMD (SMD = surface mounted device)-Bauform SOT-143 nach FIG 1 und 2. FIG 1 zeigt dabei eine Draufsicht auf ein SMD-Bauelement der Bauform SOT-143. FIG 2 zeigt eine Teilansicht eines elektronischen Bauelements nach FIG 1.

In FIG 1 bezeichnen die Bezugszeichen 1 bis 4 elektrische Anschlüsse des SMD-Bauelements. Der elektrische Anschluß (PIN) 1 bezeichnet dabei üblicherweise den Kollektor. Der elektrische Anschluß 4 bezeichnet üblicherweise einen Emitter-Anschluß. Bei einer ersten Ausführungsform des SMD-Bauelements können der elektrische Anschluß 2 einen weiteren Emitter-Anschluß und der elektrische Anschluß 3 einen Basisanschluß bezeichnen. Bei einer zweiten Ausführungsform des SMD-Bauelements können der elektrische Anschluß 2 einen Basis-Anschluß und der elektrische Anschluß 3 einen weiteren Emitter-Anschluß bezeichnen.

Bipolare Hochfrequenz-Breitband-Transistoren erreichen in der Bauform SOT-143 mit vier elektrischen Anschlüssen 1 bis 4 im Vergleich zur SMD-Bauform SOT-23, welche nur drei elektrische Anschlüsse besitzt, deutlich größere Verstärkung bei hohen Frequenzen wegen verringerter Emitter-Zuleitungs-Induktivität und wegen verringerter kapazitiver Kopplung zwischen dem Kollektor und der Basis.

Bei den bekannten Hochfrequenz-SMD-Transistoren mit zwei Emitteranschlüssen sitzt ein Halbleiter-Transistor-Chip auf dem Leiterband. Dieser Halbleiter-Transistor-Chip ist üblicherweise mit den beiden Emitter-Anschlüssen des SMD-Bauelements über zwei elektrische Bonddrähte elektrisch verbunden.

FIG 3 bis 11 zeigen Anwendungsbeispiele verschiedener Halbleiter-Chips in Verbindung mit Standard-Leiterbändern. Bei diesen Anwendungsbeispielen der FIG 3 bis 11 entstehen jeweils elektronische SMD-Bauelemente mit jeweils vier elektrischen Anschlüssen 1 bis 4. Bei FIG 3 sind auf dem elektrischen Anschluß 1 zwei Halbleiter-Chips und auf den elektrischen Anschlüssen 2 und 4 jeweils ein Halbleiter-Chip befestigt. Bei FIG 4 sind auf dem elektrischen Anschluß 1 zwei Halbleiter-Chips und auf dem elektrischen Anschluß 2 ein Halbleiter-Chip befestigt. Bei FIG 5 ist ein einziger Halbleiter-Chip auf dem elektrischen Anschluß 1 befestigt. Dieser einzige Halbleiter-Chip ist über Bonddrähte mit den elektrischen Anschlüssen 2 bis 4 kontaktiert. Bei FIG 6 sind auf den elektrischen Anschlüssen 1 und 2 jeweils ein einziger Halbleiter-Chip befestigt. Bei FIG 7 sind auf den elektrischen Anschlüssen 3 und 4 jeweils ein einziger Halbleiter-Chip befestigt. FIG 8 zeigt ein Leiterband mit den elektrischen Anschlüssen 1 bis 4 vor der Befestigung und Kontaktierung von Halbleiter-Chips auf diesem Leiterband.

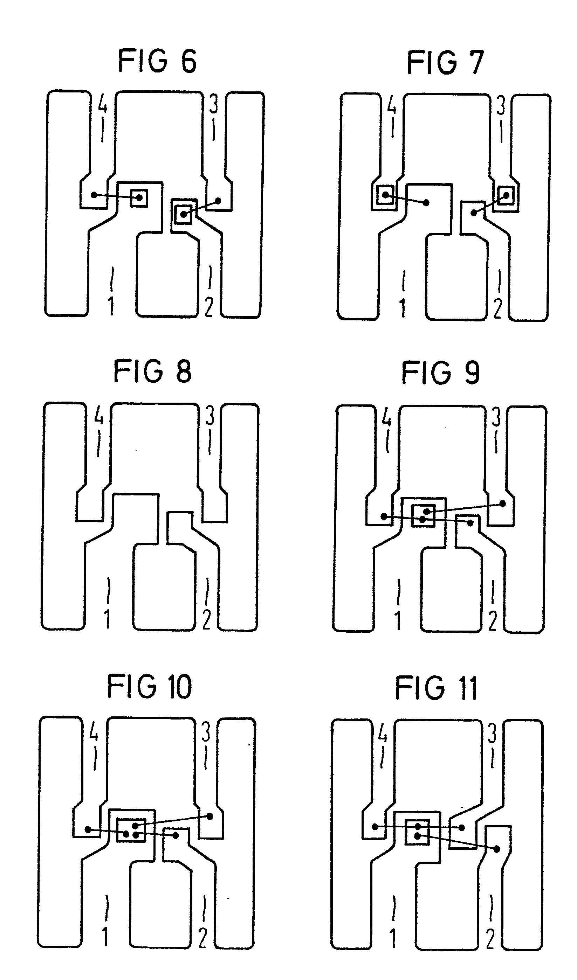

FIG 9 bis 11 zeigen drei Anwendungsbeispiele, bei denen jeweils ein einziger Halbleiter-Chip auf dem elektrischen Anschluß 1 befestigt ist. In den drei Anwendungsbeispielen der FIG 9 bis 11 werden jeweils zwei Bonddrähte zur Kontaktierung des Halbleiter-Chips mit zwei Emitter-Anschlüssen des SMD-Bauelements verwendet. Bei diesen drei Anwendungsbeispielen nach den FIG 9 bis 11 werden bei den fertigen SMD-Bauelementen jeweils zwei elektrische Emitter-Anschlüsse aus der Umhüllung des fertigen SMD-Bauelements herausgeführt.

Bei FIG 9 bilden die beiden elektrischen Anschlüsse 2 und 4 jeweils Emitter-Anschlüsse. Der Halbleiter-Chip ist mit den beiden elektrischen Anschlüssen 2 und 4 z. B. mit einem "Doppel-Nailhead" kontaktiert. Bei dem Anwendungsbeispiel nach FIG 10 besitzt der Halbleiter-Chip zwei Emitter-Kontaktierflecken. Diese beiden Emitter-Kontaktierflecken sind jeweils mit einem der beiden Emitter-Anschlüsse 2, 4 über Bonddrähte elektrisch verbunden. Bei dem Anwendungsbeispiel nach FIG 11 ist der Halbleiter-Chip mit den beiden Emitter-Anschlüssen 3, 4 über zwei Bonddrähte mittels Doppel-Nailhead-Verfahren elektrisch verbunden.

Das Verfahren, gemäß den FIG 9 und 11 auf dem Halbleiter-Chip zwei Nailheads aufeinander zu pressen, ist bei schnell laufenden Kontaktierautomaten umso kritischer, je kleiner die Kontaktierflächen bzw. die Drahtdurchmesser gewählt werden. Beim Anwendungsbeispiel nach FIG 10 können die beiden Kontaktierflecken, die auf dem Halbleiter-Chip nebeneinander angeordnet sind, verfahrenstechnisch einwandfrei kontaktiert werden.

Der vorliegenden Erfindung liegt die Aufgabe zugrunde, einen Hochfrequenz-SMD-Transistor der eingangs genannten Art und ein Leiterband der eingangs genannten Art anzugeben, die die kleinste, technisch mögliche Emitter-Induktivität aufweisen.

Diese Aufgabe wird erfindungsgemäß durch einen Hochfrequenz-SMD-Transistor nach dem Patentanspruch 1 und durch ein Leiterband nach dem Patentanspruch 5 gelöst.

Ausgestaltungen und Vorteile der Erfindung sind in den Unteransprüchen, der Beschreibung und der Zeichnung angegeben.

Die Erfindung ermöglicht die Herstellung von Hochfrequenz-SMD-Transistoren nach dem Oberbegriff des Patentanspruchs 1, die die kleinste, technisch mögliche Emitter-Induktivität besitzen.

Die Erfindung wird anhand der Zeichnung näher erläutert.

FIG 1 und 2 zeigen die SMD-Bauform SOT-143 in Draufsicht und in der Seitenansicht.

FIG 3 bis 11 zeigen verschiedene Anwendungsbeispiele mit verschiedenen Halbleiter-Chips in Verbindung mit Standard -Leiterbändern.

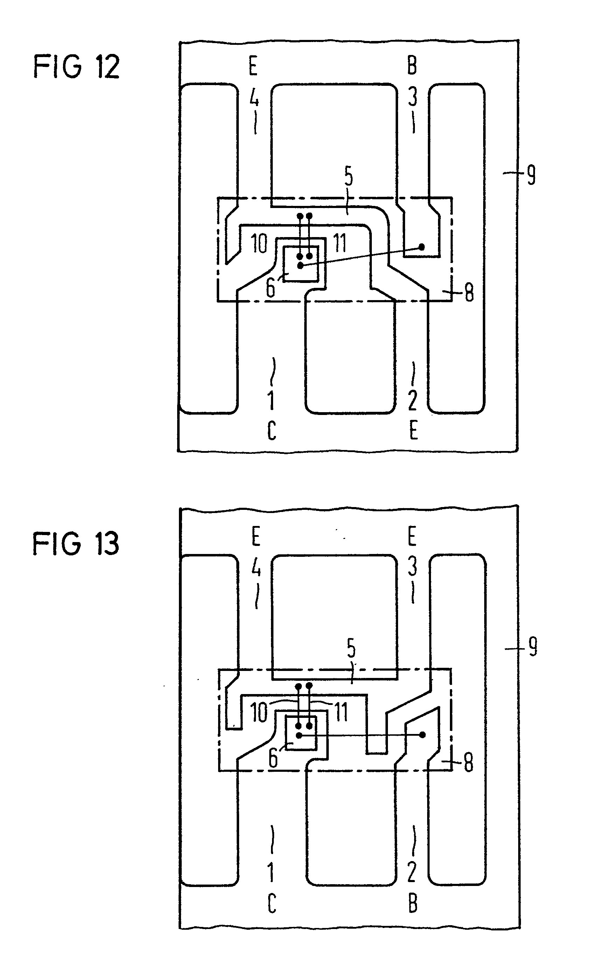

FIG 12 und 13 zeigen zwei Ausführungsbeispiele der Erfindung.

Bei FIG 12 sind die beiden Emitter-Anschlüsse 2 und 4 im Inneren des Leiterbandes 9 miteinander über einen Steg 5 elektrisch leitend verbunden. Die elektrischen Anschlüsse 2 und 4 bilden zusammen mit dem Steg 5 ein durchgehendes Stück innerhalb des Leiterbandes 9. Der Halbleiter-Chip 6 ist auf dem elektrischen Anschluß 1 befestigt. Der Halbleiter-Chip 6 ist mittels eines Bonddrahtes mit dem Basisanschluß 3 elektrisch verbunden. Der Halbleiter-Chip 6 besitzt zwei Emitter-Kontaktierflecke. Diese Emitter-Kontaktierflecke auf dem Halbleiter-Chip 6 sind über jeweils einen Bonddraht 10, 11 von jeweils optimaler Länge mit den beiden Emitter-Anschlüssen 2 und 4 und dem zwischen diesen beiden Emitter-Anschlüssen 2 und 4 angeordneten Steg 5 elektrisch leitend verbunden. Die optimale Länge der Bonddrähte 10, 11 ist so bemessen, daß die kleinste, technisch mögliche Emitter-Induktivität insgesamt erzielt wird. Das SMD-Bauelement erhält eine Umhüllung 8, vorzugsweise aus Plastik. Die elektrischen Anschlüsse 1 bis 4 werden schließlich vom Rahmen des Leiterbands 9 mechanisch getrennt und zu ihrer endgültigen Form gebogen. Beim Ausführungsbeispiel nach FIG 12 sind die beiden Emitteranschlüsse 2 und 4 diagonal gegenüberliegend angeordnet. FIG 13 zeigt ein weiteres Ausführungsbeispiel der Erfindung, bei dem dieselben Bezugszeichen wie in FIG 12 Einrichtungen mit denselben Funktionen bezeichnen. Beim Ausführungsbeispiel nach FIG 13 sind die beiden Emitter-Anschlüsse 3 und 4 nicht diagonal gegenüberliegend wie in FIG 12, sondern auf einer einzigen Längsseite der Umhüllung 8 des SMD-Bauelements herausgeführt. Auch beim Ausführungsbeispiel nach FIG 13 werden die obengenannten Vorteile der Erfindung realisiert. Auch beim Ausführungsbeispiel nach FIG 13 gibt es eine innere Verbindung der beiden Emitter-Anschlüsse 3 und 4 innerhalb des Leiterbands 9 und zwei Anschlüsse des Emitters vom Halbleiter-Chip 6 zum Leiterband hin über zwei Bonddrähte 10, 11.

**Patentansprüche**

1.  Hochfrequenz-SMD-Transistor mit zwei Emitteranschlüssen, bei dem ein Halbleitertransistor-Chip (6) auf einem Leiterband (9) befestigt und mit elektrischen Anschlüssen (1 bis 4) auf dem Leiterband (9) kontaktiert ist,
    **gekennzeichnet durch** eine einstückige Ausbildung der beiden Emitteranschlüsse des Hochfrequenz-SMD-Transistors innerhalb des Leiterbands (9) und durch zwei elektrische Verbindungen (10, 11) zwischen dem Emitter des Halbleiter-Transistor-Chips (6) und den einstückig ausgebildeten beiden Emitter-Anschlüssen.

2.  Hochfrequenz-SMD-Transistor nach Anspruch 1,
    **gekennzeichnet durch** die SMD-Bauform SOT-143.

3.  Hochfrequenz-SMD-Transistor nach Anspruch 1 oder 2,
    **gekennzeichnet durch** diagonal gegenüberliegende Emitter-Pins (3, 4).

4.  Hochfrequenz-SMD-Transistor nach Anspruch 1 oder 2,
    **gekennzeichnet durch** auf einer einzigen Längsseite des SMD-Bauelements angeordnete Emitter-Pins (3, 4).

5.  Leiterband (Lead Frame) für einen Hochfrequenz-SMD-Transistor mit zwei Emitteranschlüssen,
    **gekennzeichnet durch** eine einstückige Ausbildung der beiden Emitteranschlüsse innerhalb des Leiterbands.

6.  Leiterband nach Anspruch 5,
    **gekennzeichnet durch** Verwendung für die SMD-Bauform SOT-143.

FIG 1

FIG 2

FIG 3

FIG 4

FIG 5

FIG 6

FIG 7

FIG 8

FIG 9

FIG 10

FIG 11

FIG 12

FIG 13

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| X | GB-A-1 137 619 (ITT INDUSTRIES INC.) * Seite 1, Zeilen 13-23; Figur 2; Seite 2, Zeilen 10-102 * | 1-3,5,6 | H 01 L 23/495 H 01 L 23/66 |
| Y | --- | 4 | |
| X | GB-A-1 175 122 (PHILIPS ELECTRONIC AND ASSOCIATED INDUSTRIES LTD) * Spalte 1, Zeilen 9-21; Figuren 3,5,10; Spalte 2, Zeilen 1-39; Spalte 5, Zeile 123 - Spalte 6, Zeile 49; Spalte 8, Zeilen 12-30; Spalte 9, Zeilen 66-77 * | 1,3,5 | |
| A | --- NACHRICHTEN TECHNIK ELEKTRONIK, Band 37, Nr. 5, 1987, Seiten 169-174, Berlin, DD; H. GREINER: "Entwicklungstendenzen bei diskreten Transistoren unter besonderer beachtung der Aufsetztechnik" * Seite 172, Absatz 3.2; Figur 7; Seite 172, Absatz 3.3 * --- | 2,6 | RECHERCHIERTE SACHGEBIETE (Int. Cl.5) |
| Y | US-A-4 556 896 (INTERNATIONAL RECTIFIER CORP.) * Spalte 3, Zeilen 22-33; Figur 7 * | 4 | H 01 L 23/00 |
| A | ----- | 1,5 | |

Der vorliegende Recherchenbericht wurde für alle Patentansprüche erstellt

| Recherchenort | Abschlußdatum der Recherche | Prüfer |
|---|---|---|
| DEN HAAG | 28-09-1990 | ZEISLER P.W. |